# EUROPEAN PATENT SPECIFICATION

(11) **EP 1 542 266 B1**
(45) Date of publication and mention of the grant of the patent: **13.01.2010**
(21) Application number: 03741526.2
(22) Date of filing: 22.07.2003
(51) Int. Cl.: H01L 21/304, H01L 21/321, H05K 3/26, C09G 1/02

(54) **SEMICONDUCTOR ABRASIVE, PROCESS FOR PRODUCING THE SAME AND METHOD OF POLISHING**
HALBLEITERSCHLEIF PROZESS ZU SEINER HERSTELLUNG UND POLIERVERFAHREN
ABRASIF POUR SEMI-CONDUCTEUR, PROCEDE DE PRODUCTION DE CELUI-CI ET PROCEDE DE POLISSAGE

(30) Priority: 22.07.2002 JP 2002212679
(43) Date of publication of application: 15.06.2005
(73) Proprietor: SEIMI CHEMICAL CO., LTD., Chigasaki-city, Kanagawa, 253-8585 (JP); Asahi Glass Company, Limited, Chiyoda-ku, Tokyo 100-8405 (JP)
(72) Inventor: Kon, Yoshinori, Asahi Glass Company, Limited, Yokohama-shi, Kanagawa 221-8755 (JP); Nakazawa, Norihito, Asahi Glass Company, Limited, Yokohama-shi, Kanagawa 221-8755 (JP); Ishida, Chie, Seimi Chemical Co., Ltd., Chigasaki-shi, Kanagawa 253-8585 (JP)
(74) Representative: Müller-Boré & Partner Patentanwälte
(86) International application number: PCT/JP2003/009259
(87) International publication number: WO 2004/010487

(56) References cited:
- EP-A1- 0 826 757
- JP-A- 10 102 040
- JP-A- 2000 158 341
- JP-A- 2001 284 296
- US-A1- 2001 034 191
- US-A1- 2002 069 593
- US-A1- 2002 095 872
- PATENT ABSTRACTS OF JAPAN vol. 2000, no. 04, 31 August 2000 (2000-08-31) & JP 2000 017195 A (HITACHI CHEM CO LTD), 18 January 2000 (2000-01-18)

## Description

The present invention relates to a semiconductor polishing compound for chemical mechanical polishing in the process for producing a semiconductor device, and a polishing method. Particularly, it relates to a semiconductor polishing compound comprising cerium oxide, which is suitable for shallow trench isolation or planarization of an interlayer insulation film, a process for its production, and a polishing method.

In recent years, micro-fabrication techniques have been developed for high densification of elements to meet the demand for high integulation and high functionality of semiconductor devices. Particularly, importance of planarization techniques by chemical mechanical polishing (hereinafter referred to as CMP) is increasing. As miniaturization of semiconductor devices and multilayered structures of wirings will progress, the surface irregularity (difference in level) in each layer in the production process tends to increase. In order to prevent such a problem that this difference in level exceeds the depth of focus in photolithography so that no adequate resolution can be obtained, planarization techniques for embedded wirings and interlayer insulation films in the process for forming multilayered wirings are important.

Further, for conventional semiconductor devices, in order to electrically separate elements such as transistors, a selective thermal oxidation method of a silicon substrate, so-called a LOCOS (Local Oxidation of Silicon) method, has been employed, but there has been a problem that the separated region formed by thermal oxidation undergoes a volume expansion, whereby the surface tends to have irregularities. Further, there has been a problem that oxidation proceeds in a transverse direction and enters into the element region, and such a problem has been a hindrance to miniaturization. Therefore, in recent years, shallow trench isolation (hereinafter referred to as STI) has been introduced. In this method, in order to electrically insulating the element region, a trench is formed in a silicon substrate, and an insulating film such as a silicon oxide film is embedded in the trench.

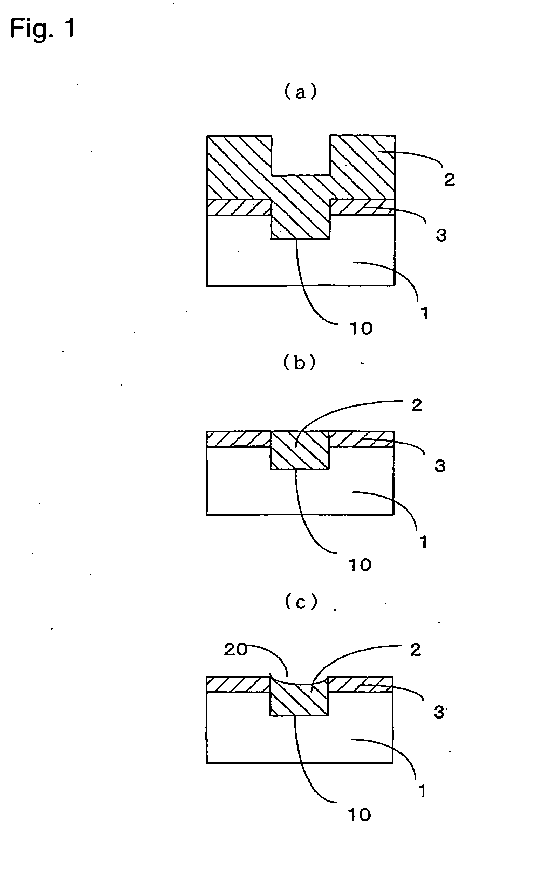

The STI process will be described with reference to Fig. 1. Fig. 1(a) shows such a state that while masking an element region with a silicon nitride film 3 or the like, a trench 10 is formed on a silicon substrate 1, and then an insulation film such as a silicon oxide film 2 is deposited so that it is embedded in the trench 10. In this state, any excess silicon oxide film 2 on the silicon nitride film 3 being a convex portion is polished and removed by CMP while permitting the insulation film to remain in the trench 10 being a concave portion, thereby to obtain an element isolation structure having the insulation film embedded in the trench. During CMP, it is common to use the silicon nitride film 3 by letting the removal rate of the silicon oxide film and the removal rate of the silicon nitride film have a selective ratio, so that polishing is terminated at the time when the silicon nitride film 3 is exposed as shown in Fig. 1(b).

Here, if the polishing is excessive, the silicon oxide film embedded in the trench 10 will be polished and recessed as shown in Fig. 1(c), whereby a structural defect such as a recess 20, so-called dishing, will result, and planarization tends to be inadequate or electrical performance tends to deteriorate. The degree of dishing depends on the width of the trench and the dishing tends to be large with a trench having a wide width.

Heretofore, silica abrasive grains have been common as abrasive grains to be used for CMP. However, the selective ratio between the removal rate of the silicon oxide film and the removal rate of the silicon nitride film is small, and, in the STI process, it has become common to employ cerium oxide abrasive grains having excellent polishing selectivity between them.

Japanese Patent 3,278,532 discloses a technique whereby rather than a concave portion, a convex portion is preferentially polished for planarization by a polishing compound comprising cerium oxide abrasive grains and, as an additive, an organic compound containing hydrophilic groups such as carboxyl groups or carboxylate groups. Here, the additive is one to improve the trench width dependency of dishing, and in order to reduce dishing even with a wide trench, it is necessary that the concentration of the above additive is high. However, if the concentration of the additive is increased, agglomeration of cerium oxide grain particles will be accelerated, whereby sedimentation of abrasive grains will result, and the dispersion stability of the polishing compound tends to deteriorate. Further, if agglomeration of grain particles takes place, scratches will increase, thus leading to a problem that the device tends to be defective.

For example, Japanese Patent 3,278,532 discloses Examples for a polishing compound solution comprising pure water, and, as abrasive grains, 1% of cerium oxide and, as an additive, 6.0% of ammonium polycarboxylate, based on the total mass of the polishing solution. However, since the additive is at a high concentration, agglomeration of the abrasive grains is remarkable, and when the polishing solution is left to stand, cerium oxide abrasive grains will be completely sedimented within a few minutes. In the polishing process of CMP, there is a waiting time during which no polishing is carried out, and sedimentation of abrasive grains is likely to result at a portion where the polishing compound is not always stirred or moved, thus causing clogging of the pipeline.

In order to prevent such sedimentation, there is a method of incorporating an additive to the polishing compound on a polishing pad or in a pipeline immediately before the polishing pad, but the mixing tends to be inadequate, the concentration tends to be non-uniform, or the polishing characteristics tend to be unstable. Further, the abrasive grains on the pad tend to be agglomerated or deposited, whereby there has been a problem that scratches will increase.

Further, cerium oxide grain particles have a large specific gravity and thus tend to be readily sedimented, while they are superior in the polishing property to conventional silica grain particles. Further, they have a serious problem that if an additive to improve the polishing property is incorporated excessively, agglomeration will be accelerated, whereby sedimentation by agglomeration tends to be remarkable.

JP-A-2000-160137 discloses, as a polishing compound useful for shallow trench isolation, a polishing compound comprising cerium oxide particles, water and an anionic surfactant, which is preferably a polishing compound falling within a regional range defined by four points i.e. point A (5.5, 0.9), point B (5.5, 3.0), point C (10.0, 3.0) and point D (9.0, 0.9), as represented by a (x, y) coordinate, wherein x is the pH, and y is the viscosity (mPa·s). And, it is disclosed that in order to realize global planarization, it is necessary to adjust the amount of the surfactant and the pH within such ranges that a polishing characteristic whereby the removal rate at a concave portion of a pattern is sufficiently small as compared with the removal rate at a convex portion, can be obtained, and the viscosity of the polishing compound is preferably from 1.0 to 2.5 mPa·s, particularly preferably from 1.0 to 1.4 mPa·s.

Further, it is disclosed that the viscosity will increase as the amount of the surfactant increases, and in order to realize a planarization characteristic with little pattern dependency by adjusting the viscosity within a range of from 1.0 to 1.4 mPa·s, the pH of the polishing compound after incorporation of the surfactant is preferably from 5.5 to 9, particularly preferably from 6 to 8.5, and within this pH range, the selective ratio between the removal rate of the silicon oxide film and the removal rate of the silicon nitride film, can be made large. Further, it is exemplified to preliminarily incorporate a very small amount of a dispersant to the abrasive grains.

However, if a polishing compound is prepared in accordance with Examples given in this publication, when a surfactant is added to a dispersion of abrasive grains, the abrasive grains will be agglomerated to have an average particle diameter which is from 2 to 3 times the average particle diameter in the dispersion of grain particles. Accordingly, the dispersibility of abrasive grains in the polishing compound was poor, and the abrasive grains were sedimented within a few minutes, whereby it was difficult to use such a polishing compound, and the removal rate was also inadequate. Further, in a case where the concentration of the surfactant is high, dishing fluctuation is small, and the planarization characteristic is excellent. However, with a polishing compound prepared in accordance with an Example wherein the concentration of the surfactant is lower, dishing fluctuation was substantial, and the planarization characteristic was poor.

Further, if the concentration of the surfactant becomes high, the number of scratches sharply increases. This is believed to be attributable to that if the concentration of the surfactant is high, agglomeration and sedimentation of cerium oxide grain particles are accelerated, and they are accumulated on the polishing pad. Namely, it is considered that if coarse particles causing scratches, are present in abrasive grains even slightly, the grain particles will be agglomerated and accumulated on the polishing pad therby to cause an increase of scratches. Further, it is also considered that there may be a case where agglomerates of abrasive grains grown by agglomeration themselves will cause scratches.

US-A-2002/0069593 describes a cerium oxide abrasive slurry having, dispersed in a medium, cerium oxide particles whose primary particles have a median diameter of from 30 nm to 250 nm, a maximum particle diameter of 600 nm or smaller, and a specific surface area of from 7 to 45 m²/g, and slurry particles having a median diameter of from 150 nm to 600 nm.

As described in the foregoing, in the prior art, no polishing compound was available which had both dispersion stability of the polishing compound and excellent scratch characteristics, and excellent polishing planarization characteristics, and it was difficult to obtain a semiconductor device having adequate properties.

Under the circumstances, it is an object of the present invention to solve the above problems and to provide a semiconductor polishing compound which simultaneously has dispersion stability, excellent scratch characteristics and excellent polishing planarization characteristics.

The present invention provides a semiconductor polishing compound comprising cerium oxide abrasive grains, water and an anionic additive, wherein the additive is at least one member selected from the group consisting of polyacrylic acid and ammonium polyacrylate, the cerium oxide abrasive grains have a positive surface potential, the pH of the polishing compound at 25°C is from 3.5 to 6, and the total concentration of the additive is from 0.01 to 0.5% based on the total mass of the polishing compound.

Further, the present invention provides a polishing method which comprises bringing a surface to be polished and a polishing pad in contact with each other and relatively moving them, while supplying a semiconductor polishing compound, **characterized in that** the polishing compound is the above-described semiconductor polishing compound, and the surface to be polished is a semiconductor substrate.
Fig. 1 is a schematic cross-sectional view illustrating a process for polishing a semiconductor device substrate by a semiconductor polishing compound.
Fig. 2 is a view showing an example of a polishing apparatus which may be used for the polishing method of the present invention.

Now, the present invention will be described in detail.

In the present invention, cerium oxide is used as abrasive grains. Heretofore, it has been known that cerium oxide abrasive grains show a specifically high removal rate in polishing of a glass type material including a silicon oxide film. Namely, when cerium oxide is in contact with silicon oxide in the material to be polished, a chemical bond will be formed between the two, which creates a grinding power higher than the mere mechanical action. Accordingly, in polishing by means of cerium oxide, it is important to control the contact of the abrasive grains with the object to be polished.

In a STI process or a CMP process for an interlayer insulation film, it is desired to efficiently planarize the object to be polished such as a silicon oxide film having surface irregularities. Namely, it is preferred to selectively polish convex portions. To realize such selective polishing, it is necessary to incorporate in the polishing compound an additive which is to be adsorbed on the surface of cerium oxide abrasive grains to prevent direct contact with the object to be polished such as a silicon oxide film thereby to control polishing. By incorporating such an additive, if a high pressure is exerted, the additive adsorbed on the surface of cerium oxide abrasive grains, will be peeled off to cause the contact with the object to be polished, whereby polishing will proceed.

In a common polishing method wherein an object to be polished is pressed against e.g. a polishing pad and relatively moved, the pressure exerted to the surface of the object to be polished differs locally depending upon the surface contour. At a convex portion, the pressure exerted will be high as compared with at a concave portion. Accordingly, at the convex portion, the additive adsorbed on the surface of cerium oxide abrasive grains is likely to be peeled off to readily form the contact with the object to be polished thereby to facilitate the polishing, and thus, it becomes possible to selectively polish the convex portion against the concave portion.

The cerium oxide surface in an aqueous dispersion is positively charged within a range of from neutral to acidic, and as the anionic additive, polyacrylic acid or ammonium polyacrylate is employed also in the present invention.

Further, in the STI process, usually, selectivity is given between the removal rates of the silicon oxide film and the silicon nitride film, so that the silicon nitride film is used as a stopper. In an aqueous dispersion medium, the surface of the silicon oxide film is negatively charged, and the surface of the silicon nitride film is positively charged, within a range of from neutral to acidic (about pH 3), whereby the above-mentioned anionic additive will selectively be adsorbed on the surface of the silicon nitride film. Therefore, contact of the silicon nitride film with the cerium oxide abrasive grains will be prevented thereby to provide selectivity between the removal rates of the silicon oxide film and the silicon nitride film.

With a conventional semiconductor polishing compound, as mentioned above, in order to selectively polish convex portions and to provide selectivity between the removal rates of the silicon oxide film and the silicon nitride film, it has been believed desirable that the concentration of the above-mentioned additive is within a range of from 2 to 3%, and the pH of the polishing compound is at a level of from 7 to 8 i.e. in the vicinity of neutral. However, under these conditions, agglomeration of abrasive grains by the additive has been remarkable, and the dispersion stability of abrasive grains has been inadequate although the planarization characteristics by polishing may be excellent.

As a result of an extensive study, the inventors of the present invention have found that by selecting the pH range of the polishing compound, it is possible to improve the planarization characteristics by polishing even when the amount of the additive in the polishing compound is reduced, and further it is possible to increase the dispersion stability of abrasive grains in the polishing compound, and thus have arrived at the present invention. In the semiconductor polishing compound of the present invention, the concentration of the additive is from 0.01 to 0.5% (mass ratio) based on the total mass of the polishing compound. However, with such a concentration range, it has heretofore been considered that the concentration of the additive is too low and inadequate to provide the necessary polishing characteristics. However, if the pH of the polishing compound is from 3.5 to 6, it is possible to provide adequate polishing characteristics at a concentration of the additive lower than before. Further, if the concentration of the additive is reduced, agglomeration of abrasive grains by the additive tends to scarcely occur, whereby the dispersion stability will be improved, and it will be possible to simultaneously satisfy the planarization characteristics by polishing and the dispersion stability of abrasive grains.

Within the pH range in the present invention, as compared with in the vicinity of neutral, the positive potential on the cerium oxide surface will increase, whereby the additive tends to be readily adsorbed on the cerium oxide surface. Further, in a case where the negative charge of the additive is substantial, due to the electrical repulsion of the additive particles among themselves, the additive tends to be hardly adsorbed in multilayers on the cerium oxide surface. However, in this pH range, the degree of dissociation of the additive itself will be small, and the negative charge will be small, whereby multiple adsorption will be possible. Further, in a case where a water-soluble organic polymer having carboxylic acid group, i.e polyacrylic acid, is used as the additive, if the water-soluble organic polymer is not dissociated, the water-soluble organic polymer particles among themselves tend to be entangled by the hydrogen bonds on the cerium oxide surface, and they tend to be adsorbed in multilayers. Therefore, in the pH range in the present invention, even if the additive concentration is low, the additive will adequately be adsorbed on the surface of cerium oxide abrasive grains, whereby polishing planarization characteristics can be provided.

The pH of the polishing compound of the present invention is from 3.5 to 6, particularly preferably from 4 to 5. If the pH is too low, the amount of the additive to be adsorbed on the surface of the silicon nitride film tends to be extremely small, whereby the surface protection of the silicon nitride film tends to be inadequate. Further, the electric charge of the additive will be small, the adsorbability of the additive to the cerium oxide abrasive grains will be weakened. Further, the electric charge of the additive adsorbed on the cerium oxide surface will also be small, whereby the electrical repulsion will decrease, and the dispersion stability of the polishing compound tends to deteriorate. Inversely, if the pH is too high, a large amount of the additive will be required to provide the planarization characteristics, whereby the dispersibility of the cerium oxide abrasive grains tends to be poor, whereby agglomeration and sedimentation of the polishing compound tend to proceed.

In the present invention, the cerium oxide abrasive grains are not particularly limited, but, for example, cerium oxide abrasive grains disclosed in JP-A-11-12561 or JP-A-2001-35818 may preferably be used. Namely, a cerium oxide powder obtained by adding an alkali to an ammonium aqueous solution of cerium (IV) nitrate to prepare a cerium hydroxide gel, followed filtration, washing and firing, may preferably be used. Further, cerium oxide abrasive grains obtained by pulverizing and firing cerium carbonate of high purity, followed by further pulverization and classification, may also preferably be used.

The average particle diameter of the cerium oxide abrasive grains is preferably from 0.05 to 0.5 µm, particularly preferably from 0.1 to 0.3 µm, further preferably from 0.1 to 0.2 µm. If the average particle diameter is too large, abrasion flaws such as scratches are likely to be formed on the surface of the semiconductor substrate. On the other hand, if the average particle diameter is too small, the removal rate tends to be low. Further, as the proportion of the surface area per unit volume is large, the polishing compound is susceptible to the influence of the surface condition, and depending upon the conditions such as the pH and the concentration of the additive, the polishing compound may tend to be agglomerated.

For the measurement of the average particle diameter, a particle size distribution meter of e.g. laser diffraction-scattering type, dynamic light scattering type or photon correlation type, may be used. In a case where the particle diameter is large to some extent and the grains are likely to be sedimented, it is preferred to use a laser diffraction-scattering type particle size distribution meter, and the above-mentioned range is a preferred range in a case where the average particle diameter is measured by using a laser diffraction-scattering type particle size distribution meter.

The anionic additive in the present invention is at least one member selected from the group consisting of a polyacrylic acid and a polymer having at least some of carboxylic acid groups in a polyacrylic acid substituted by ammonium carboxylate groups (hereinafter referred to as an ammonium polyacrylate). In a case where an inorganic acid or an inorganic acid salt which will be described hereinafter, is incorporated to the polishing compound of the present invention, it is particularly preferred to employ an ammonium polyacrylate to adjust the pH within the range for the polishing compound of the present invention.

Here, in a case where a water-soluble organic polymer such as an ammonium polyacrylate is used as the additive, its molecular weight is preferably from 1,000 to 50,000, particularly preferably from 2,000 to 30,000.

As the inorganic acid or the inorganic acid salt in the present invention, nitric acid, sulfuric acid, hydrochloric acid, phosphoric acid, boric acid, carbonic acid and their ammonium salts or potassium salts may, for example, be mentioned. By such an inorganic acid or an inorganic acid salt, the pH of the polishing compound can be adjusted.

As the production process for the semiconductor polishing compound of the present invention, in view of the long term storage stability of the polishing compound or the stability of various polishing characteristics, a process for producing a semiconductor polishing compound is adopted which comprises preparing liquid A comprising cerium oxide abrasive grains and water, and liquid B comprising the additive and water, and mixing liquids A and B prior to the polishing. The method for mixing liquids A and B may be a method of mixing them on a polishing pad or in a pipeline immediately before the polishing pad. However, the semiconductor polishing compound of the present invention undergoes substantially no agglomeration even after such mixing and is stable for a practically sufficient period of time, and therefore they may be preliminarily be mixed. Namely, a commonly employed semiconductor polishing compound-supplying system may be utilized whereby liquids A and B are put into a semiconductor polishing compound storage tank and stirred and mixed by a propeller stirring machine, or the polishing compound may be continuously moved by a circulation line.

In the present invention, in order to sufficiently mix the cerium oxide abrasive grains and the additive and to stabilize the adsorbed state of the additive on the grain surface, it is preferred to preliminarily mix and stir liquid A comprising the cerium oxide grain particles and water with liquid B comprising the additive and water and then use the obtained polishing compound solution. The polishing compound solution may be used immediately after mixing liquids A and B, but it is preferred to use it at least a few minutes after the mixing. It is particularly preferred to use the polishing compound upon expiration of at least 15 minutes after the mixing. By supplying the semiconductor polishing compound prepared by mixing, via a pump, to a polishing apparatus, it is possible to carry out CMP polishing constantly. To the supply line, a circulation line may be provided for uniformity of the semiconductor polishing compound.

For the preparation of liquid A, it is preferred to employ a method of dispersing cerium oxide abrasive grains in pure water or deionized water, and at the time of dispersion, it is preferred to employ an ultrasonic disperser whereby agglomerates are disintegrated by the energy of ultrasonic waves to disperse abrasive grains in water, or a homogenizer, or Homogenizer (tradename, manufactured by Sugino Machine) or Nanomizer (tradename, manufactured by Yoshida Kikai Co., Ltd.) whereby agglomerates are disintegrated by the collision kinetic energy by collision of abrasive grains one another to disperse abrasive grains in water. Further, it is also preferred to simultaneously add a dispersant at that time. Here, the dispersant is one to be added to stably disperse abrasive grains in a dispersing medium such as pure water, and as such a dispersant, the same one as the above-described additive may be used. Namely, the additive in the present invention may be added not only to liquid B but also to liquid A as one having a function as a dispersant.

When a dispersant is to be added, its concentration is preferably within a range of from 0.1 to 1.0%, more preferably from 0.3 to 0.7%, by a mass ratio to the mass of the cerium oxide abrasive grains. If the concentration of the dispersant is lower than this concentration range, the dispersibility of abrasive grains tends to be inadequate, and if the concentration of the dispersant is higher than this range, agglomeration of abrasive grains tends to gradually proceed.

For the preparation of liquid B, a method of dissolving the above-described additive to pure water or deionized water, may, for example, be mentioned. Further, by incorporating an inorganic acid or an inorganic salt to liquid B to preliminarily carry out the pH adjustment, it is possible to bring the pH of the semiconductor polishing compound to be prepared by mixing liquids A and B, to a predetermined level. Further, as a method of bringing the pH of the semiconductor polishing compound after the mixing to the predetermined level, a method of controlling the pH of the above additive, may also be employed. For example, in a case where a copolymer made of a carboxylic acid with a carboxylate, is used as the additive, it is possible to employ a method of adjusting the pH by controlling the polymerization ratio of the carboxylic acid with the carboxylate.

The concentrations of liquids A and B may, for example, be made to be twice the concentration at the time of use for polishing, so that the prescribed concentration may be obtained by mixing liquids A and B in a mass ratio of 1:1. Further, for the sake of convenience for storage or transportation, the concentrations of liquids A and B may, for example, be made so that the concentrations of the components such as the abrasive grains, the additive, etc. would be about ten times the concentration at the time of use for polishing, and they are diluted to a concentration of twice at the time of use, and liquids of A and B are further mixed in a mass ratio of 1:1 to obtain the prescribed concentration. Further, liquids A and B having concentrations of ten times and deionized water may be mixed in a mass ratio of 1:1:8 to obtain the prescribed concentration. However, the method for adjusting the concentration is not limited to such specific methods.

As the semiconductor substrate to be polished by the semiconductor polishing compound of the present invention, the above-mentioned STI substrate for shallow trench isolation may be mentioned as a preferred example. As described above, the semiconductor polishing compound of the present invention has high selectivity for the removal rate against a silicon oxide film and a silicon nitride film and is capable of polishing a silicon oxide film at a high removal rate with no substantial dishing. Thus, the polishing compound of the present invention is effective for polishing a semiconductor substrate having a silicon oxide film 2 and a silicon nitride film 3 formed on a silicon substrate 1. Further, as an application, the polishing compound of the present invention is effective also for polishing for planarization of an interlayer insulation film between multilayer wirings.

The silicon oxide film 2 may, for example, be a so-called PE-TEOS film formed by a plasma CVD method using tetraethoxysilane as starting material. Further, a so-called HDP film formed by a high density plasma CVD method may also be mentioned. The silicon nitride film 3 may, for example, be one formed by a low pressure CVD method or a plasma CVD method using silane or dichlorosilane and ammonia as starting materials. Further, instead of the silicon oxide film, a SiOF film, a BPSG (Boro-Phospho-Silicate Glass) film or a PSG (Phospho-Silicate Glass) film may, for example, be also used. Further, instead of the silicon nitride film, a SiON film or a SiCN film may, for example, be used.

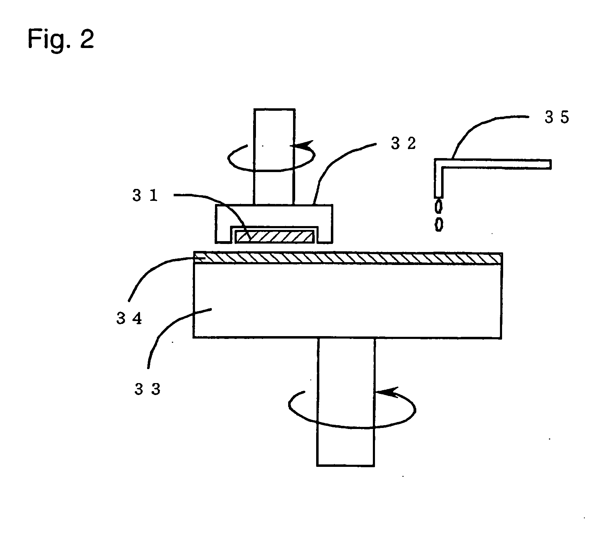

As a method for polishing a semiconductor substrate by means of the semiconductor polishing compound of the present invention, preferred is a polishing method which comprises bringing a surface to be polished, of the semiconductor substrate, and a polishing pad in contact with each other and relatively moving them. As the polishing apparatus, a common polishing apparatus may be used. For example, Fig. 2 is a view showing an example of a polishing apparatus which can be used for the polishing method of the present invention. This is a system wherein while supplying the semiconductor polishing compound 36 from a polishing compound-supply pipe 35, a semiconductor substrate 31 is held by a polishing head 32 and is brought in contact with a polishing pad 34 bonded to the surface of a polishing table 33, and the polishing head 32 and the polishing table 33 are rotated for relative movement, but the polishing apparatus is not limited thereto.

Here, the polishing head 32 may perform not only rotation but also a linear movement. The polishing table 33 and the polishing pad 34 may be of the same size as or smaller than the semiconductor substrate 31. In such a case, it is preferred to relatively move the polishing head 32 and the polishing table 33, so that the entire surface of the semiconductor substrate can be polished. Otherwise, the polishing table 33 and the polishing pad 34 may not be of a rotational type, but may for example be of a type moving in one direction by a belt system.

The polishing conditions are not particularly limited, but the removal rate can be improved by exerting a load to the polishing head 32 to change the pressing pressure against the polishing pad 34. The polishing pressure at that time is preferably at a level of from 0.5 to 50 kPa, and from the viewpoint of the uniformity of the removal rate within the semiconductor substrate, flatness and prevention of polishing defects such as scratches, it is particularly preferably at a level of from 3 to 40 kPa. Further, the rotational speeds of the polishing table and the polishing head are preferably from about 50 to 500 rpm, but not limited thereto.

The polishing pad may be one made of e.g. a common non-woven fabric, a foamed polyurethane, a porous resin or a non-porous resin. Further, lattice, concentric or helical grooves may be formed on the surface of the polishing pad in order to promote the supply of the semiconductor polishing compound or to let a certain amount of the semiconductor polishing compound stay there.

Now, Examples of the present invention will be described. In each Example, the measurement of the pH was carried out at 25°C.

### EXAMPLE 1

Cerium oxide abrasive grains and, as a dispersant, an ammonium polyacrylate having a molecular weight of 5,000 were mixed in a mass ratio of 100:0.7 in deionized water with stirring, and subjected to ultrasonic dispersion and filtering to obtain a mixed liquid having a concentration of 10% by mass ratio of abrasive grains based on the total mass of the liquid (hereinafter "%" in Examples shows such a proportion by mass ratio) and a concentration of the dispersant of 0.07%. This liquid was diluted five times with deionized water to prepare an abrasive grain mixed liquid A having an abrasive grain concentration of 2% and a dispersant concentration of 0.014%. The abrasive grain mixed liquid A had a pH of 7.6 and an average particle diameter of 0.18 µm.

Then, an ammonium polyacrylate having a molecular weight of 5,000 was dissolved in deionized water, and the pH adjustment was carried out with a 0.070% nitric acid aqueous solution to bring the pH to from 5.7 to 5.8, to prepare an additive liquid B having an ammonium polyacrylate concentration of 0.60%. The abrasive grain mixed liquid A and the additive liquid B were mixed with stirring to prepare a semiconductor polishing compound having an abrasive grain concentration of 1%, a concentration of an ammonium polyacrylate added as a dispersant of 0.007%, a concentration of an ammonium polyacrylate added from the additive liquid of 0.3% and a pH of 6.0. The measurement of the pH was carried out by pH 81-11 manufactured by Yokogawa Electric Corporation. The composition, pH and average particle diameter of the polishing compound and the time until the abrasive grains were agglomerated and sedimented, are shown in Table 1, and the results of evaluation of the polishing characteristics are shown in Table 2.

In both the polishing compound and the abrasive grain mixed liquid A, the average particle diameter was 0.18 µm. Namely, by the mixing with the additive liquid B, agglomeration of abrasive grains did not proceed.

This semiconductor polishing compound was left to stand still to evaluate the dispersion stability, whereby the dispersion was maintained even upon expiration of at least one week. This dispersed state was at the same level as the abrasive grain mixed liquid A having no additive added, and thus, the dispersibility was excellent. For the measurement of the particle size distribution, a laser scattering-diffraction apparatus (tradename: LA-920, manufactured by Horiba, Ltd.) was used.

Further, in order to evaluate the polishing characteristics, polishing was carried out by using a CMP polishing apparatus (tradename: Mirra, manufactured by Applied Materials). At that time, as a polishing pad, a double layer pad IC-1400, K-groove, manufactured by Rodel, was used, and for conditioning of the polishing pad, MEC100-PH3.5L manufactured by Mitsubishi Materials Corporation, was used. The polishing pressure was 21 kPa, and the rotational speeds of the polishing table and the polishing head were 123 rpm and 97 rpm, respectively.

For the measurement of the removal rate, a film thickness meter UV-1280SE, manufactured by KLA-Tencor, was used, and for the measurement of difference in level of the surface, profiler HRP-100, manufactured by KLA-Tencor, was used. For the evaluation of scratches, SF6420, manufactured by KLA-Tencor was used. As a semiconductor substrate (solid film) as an object to be polished, a blanket substrate comprising a PE-TEOS silicon oxide film and a silicon nitride film, manufactured by International SEMATECH, was used. Further, for the evaluation of the polishing characteristics of a pattern wafer, STI pattern wafer 964CMP000 or 864CMP000, manufactured by International SEMATECH, was used. The oxide film embedded therein was a PE-TEOS silicon oxide film having a thickness of 800 nm.

With respect to the polishing characteristics of the blanket (solid film), the removal rate (Oₓ) of the silicon oxide film was 220 nm/min, and the removal rate (N) of the silicon nitride film was 6.1 nm/min, whereby the selective ratio Oₓ/N of the removal rates was 36 i.e. sufficiently large. The polishing time of the pattern wafer was 135 seconds, the fluctuation in dishing was 65 nm, and the number of scratches was from 20 to 30.

The fluctuation in dishing was evaluated as follows. Namely, the difference between the maximum value and the minimum value of dishing of line-and-space patterns with widths of 10, 25, 50, 100, 250 and 500 µm, within one chip, was taken as the fluctuation. Here, the line-and-space patterns are simulative patterns for shallow trench isolation and patterns wherein a trench being a concave portion and a silicon nitride film masking portion being a convex portion are alternately arranged. Within one chip, there are line-and-space patterns having various line widths, but in this evaluation, the respective widths are equally spaced, and evaluation was carried out with respect to patterns having the above-mentioned six types of widths.

### EXAMPLE 2

In the same manner as in Example 1, an abrasive grain mixed liquid A was prepared, and an additive liquid C having a pH of about 4.4 was prepared in the same manner as in Example 1 except that the concentration of the aqueous nitric acid solution to carry out the pH adjustment in the preparation of the additive liquid B was changed to 0.044%, and the concentration of an ammonium polyacrylate was changed to 0.017%. The abrasive grain mixed liquid A and the additive liquid C were mixed with stirring to obtain a semiconductor polishing compound having an abrasive grain concentration of 1%, a concentration of an ammonium polyacrylate added as a dispersant of 0.007%, a concentration of an ammonium polyacrylate added from the additive liquid of 0.085% and a pH of 5.0.

Evaluation of the above semiconductor polishing compound was carried out in the same manner as in Example 1. The composition, pH and the average particle diameter of the polishing compound are shown in Table 1, and other evaluation results are shown in Table 2.

### EXAMPLE 3

In the same manner as in Example 1, an abrasive grain mixed liquid A was prepared, and an additive liquid D having a pH of about 2.9 was prepared in the same manner as in Example 1 except that the concentration of the aqueous nitric acid solution to carry out the pH adjustment in the preparation of the additive liquid B was changed to 0.012%, and the concentration of an ammonium polyacrylate was changed to 0.02%. The abrasive grain mixed liquid A and the additive liquid D were mixed with stirring to prepare a semiconductor polishing compound having an abrasive grain concentration of 1%, a concentration of an ammonium polyacrylate added as a dispersant of 0.007%, a concentration of an ammonium polyacrylate added from the additive liquid of 0.01% and a pH of 4.0.

Evaluation of the above semiconductor polishing compound was carried out in the same manner as in Example 1. The composition, pH and average particle diameter of the polishing compound are shown in Table 1, and other evaluation results are shown in Table 2.

### EXAMPLE 4

An abrasive grain mixed liquid E having an abrasive grain concentration of 2% and a dispersant concentration of 0.01%, was prepared in the same manner as in Example 1 except that in the preparation of the abrasive grain mixed liquid A in Example 1, the concentration of an ammonium polyacrylate as the dispersant was changed to 0.5% based on the cerium oxide abrasive grains. The pH was 7.6, and the average particle diameter was 0.18 µm. Then, in the same manner as in Example 1, the additive liquid B was prepared, and the abrasive grain mixed liquid E and the additive liquid B were mixed with stirring to prepare a semiconductor polishing compound having an abrasive grain concentration of 1%, a concentration of an ammonium polyacrylate added as a dispersant of 0.005%, a concentration of an ammonium polyacrylate added from the additive liquid of 0.3% and a pH of 6.0.

Evaluation of the above semiconductor polishing compound was carried out in the same manner as in Example 1 except that as a polishing pad, a single layer pad IC-1000, K-groove, manufactured by Rodel, was used, and as a semiconductor substrate, a HDP silicon oxide film was used instead of the PE-TEOS silicon oxide film, and as a pattern wafer, one having a silicon oxide film having a thickness of 800 nm embedded by a HDP method on a substrate having trenches in a pattern of STI pattern wafer 964 manufactured by International SEMATECH, was used. The composition, pH and average particle diameter of the polishing compound are shown in Table 1, and other evaluation results are show in Table 2.

### EXAMPLE 5

In the same manner as in Example 4, the abrasive grain mixed liquid E was prepared, and in the same manner as in Example 2, the additive liquid C was prepared. The abrasive grain mixed liquid E and the additive liquid C were mixed with stirring to prepare a semiconductor polishing compound having an abrasive grain concentration of 1%, a concentration of an ammonium polyacrylate added as a dispersant of 0.005%, a concentration of an ammonium polyacrylate added from the additive liquid of 0.085% and a pH of 5.0.

Evaluation of the above semiconductor polishing compound was carried out in the same manner as in Example 4. The composition, pH and average particle diameter of the polishing compound are shown in Table 1, and other evaluation results are shown in Table 2.

### EXAMPLE 6

In the same manner as in Example 4, the abrasive grain mixed liquid E was prepared, and an additive liquid F having a pH of about 4.4, was prepared in the same manner as in Example 1 except that in the preparation of the additive liquid B, the concentration of the aqueous nitric acid solution to carry out the pH adjustment was changed to 0.072%, and the concentration of an ammonium polyacrylate was changed to 0.306%. The abrasive grain mixed liquid E and the additive liquid F were mixed with stirring to prepare a semiconductor polishing compound having an abrasive grain concentration of 1%, a concentration of an ammonium polyacrylate added as a dispersant of 0.005%, a concentration of an ammonium polyacrylate added from the additive liquid of 0.153% and a pH of 5.0.

Evaluation of the above semiconductor polishing compound was carried out in the same manner as in Example 1 except that as a polishing pad, a double layered pad IC-1400, K-groove, manufactured by Rodel, was used, the polishing pressure was 28 kPa, the rotational speeds of the polishing table and the polishing head were 123 rpm and 127 rpm, respectively, and as a pattern wafer one having a silicon oxide film having a thickness of 600 nm embedded by a HDP method on a substrate having trenches formed in a pattern of STI pattern wafer 964, manufactured by International SEMATECH, was used. The composition, pH and average particle diameter of the polishing compound are shown in Table 1, and other evaluation results are shown in Table 2.

### EXAMPLE 7

In the same manner as in Example 4, the abrasive grain mixed liquid E was prepared, and an additive liquid G having a pH of about 4.4, was prepared in the same manner as in Example 1 except that in the preparation of the additive liquid B, the concentration of the aqueous nitric acid solution to carry out the pH adjustment was changed to 0.079%, and the concentration of an ammonium polyacrylate was changed to 0.34%. The abrasive grain mixed liquid E and the additive liquid G were mixed with stirring to prepare a semiconductor polishing compound having an abrasive grain concentration of 1%, a concentration of an ammonium polyacrylate added as a dispersant of 0.005%, a concentration of an ammonium polyacrylate added from the additive liquid of 0.17% and a pH of 5.0.

Evaluation of the above semiconductor polishing compound was carried out in the same manner as in Example 6. The composition, pH and average particle diameter of the polishing compound are shown in Table 1, and other evaluation results are shown in Table 2. Here, the polishing time of pattern wafer in Table 2 is the time required for planarization by eliminating difference in level of the pattern, where 50 nm of the oxide film is remained on the silicon nitride film 3. The value of the dishing fluctuation is the fluctuation in thickness of the oxide film embedded in the trench 10.

In this Example, the oxide film was not completely removed, but as compared with other Examples, a good result was obtained with an extremely small fluctuation. In the case of the semiconductor polishing compound in this Example, if the thickness of the silicon oxide film embedded by the HDP method is made to be thin at a level of about 550 nm, it is possible to completely remove the oxide film on the silicon nitride film while reducing the fluctuation. Further, it is also possible to remove the remaining oxide film of about 50 nm by another polishing compound, after being planarized.

### EXAMPLE 8 (Comparative Example)

In the same manner as in Example 1, the abrasive grain mixed liquid A was prepared. As an additive liquid, a liquid having an ammonium polyacrylate added to pure water so that the concentration would be 2.0%, was employed. The abrasive grain mixed liquid A and the additive liquid were mixed with stirring to prepare a semiconductor polishing compound having an abrasive grain concentration of 1%, a concentration of an ammonium polyacrylate added as a dispersant of 0.007% and a concentration of an ammonium polyacrylate added from the additive liquid of 1.0%. The pH was 7.0.

Evaluation of the above semiconductor polishing compound was carried out in the same manner as in Example 1. The composition, pH and average particle diameter of the polishing compound are shown in Table 1, and other evaluation results are shown in Table 2. The average particle diameter of the abrasive grain mixed liquid A was 0.18 µm, while the average particle diameter of the polishing compound was 0.27 µm, thus showing that agglomeration started to proceed. Further, the fluctuation in dishing was large.

### EXAMPLE 9 (Comparative Example)

A semiconductor polishing compound having an abrasive grain concentration of 1%, a concentration of an ammonium polyacrylate added as a dispersant of 0.007% and a concentration of an ammonium polyacrylate added from the additive liquid of 1.5%, was prepared in the same manner as in Example 8 except that the concentration of an ammonium polyacrylate in the additive liquid was 3.0%. The pH was 7.0.

Evaluation of the above semiconductor polishing compound was carried out in the same manner as in Example 1. The composition, pH and average particle diameter of the polishing compound are shown in Table 1, and other evaluation results are shown in Table 2. The average particle diameter of the abrasive grain mixed liquid A was 0.18 µm, while the average particle diameter of the polishing compound was 0.39 µm, and the abrasive grains in the polishing compound were agglomerated and sedimented in a few minutes.

### EXAMPLE 10 (Comparative Example)

A semiconductor polishing compound having an abrasive grain concentration of 1%, a concentration of an ammonium polyacrylate added as a dispersant of 0.007% and a concentration of an ammonium polyacrylate added from the additive liquid of 2.0%, was prepared in the same manner as in Example 8 except that the concentration of an ammonium polyacrylate in the additive liquid was changed to 4.0%. The pH was 7.0.

Evaluation of the above semiconductor polishing compound was carried out in the same manner as in Example 1. The composition, pH and average particle diameter of the polishing compound are shown in Table 1, and other evaluation results are shown in Table 2. The average particle diameter of the abrasive grain mixed liquid A was 0.18 µm, while the average particle diameter of the polishing compound was 0.46 µm, and the abrasive grains in the polishing compound were agglomerated and sedimented in a few minutes. Further, with respect to the polishing of a pattern wafer, it was impossible to completely polish it even if the polishing time was prolonged. The number of scratches was also very large.

**TABLE 1**

| | Concentration of cerium oxide (%) | Concentration of ammonium polyacrylate as a dispersant (%) | Concentration of ammonium polyacrylate in the additive liquid (%) | pH | Average particle diameter (µm) | Time for agglomeration and sedimentation |
|---|---|---|---|---|---|---|
| Ex. 1 | 1.0 | 0.007 | 0.3 | 6.0 | 0.18 | >1 week |
| Ex. 2 | 1.0 | 0.007 | 0.085 | 5.0 | 0.18 | >1 week |
| Ex. 3 | 1.0 | 0.007 | 0.01 | 4.0 | 0.18 | >1 week |
| Ex. 4 | 1.0 | 0.005 | 0.3 | 6.0 | 0.18 | >1 week |
| Ex. 5 | 1.0 | 0.005 | 0.085 | 5.0 | 0.18 | >1 week |
| Ex. 6 | 1.0 | 0.005 | 0.153 | 5.0 | 0.18 | >1 week |
| Ex. 7 | 1.0 | 0.005 | 0.17 | 5.0 | 0.18 | >1 week |
| EX. 8 | 1.0 | 0.007 | 1.0 | 7.0 | 0.27 | <a few tens minutes |
| EX. 9 | 1.0 | 0.007 | 1.5 | 7.0 | 0.39 | <a few minutes |
| Ex. 10 | 1.0 | 0.007 | 2.0 | 7.0 | 0.46 | <a few minutes |

**TABLE 2**

| | Removal rate of silicon oxide film Oₓ (nm/min) | Removal rate of silicon nitride film N (nm/min) | Removal rate ratio Oₓ/N | Polishing time of pattern wafer (sec) | Dishing fluctuation (nm) | Scratches (number/wafer) |
|---|---|---|---|---|---|---|
| Ex. 1 | 220 | 6.1 | 36 | 135 | 65 | 20-30 |
| Ex. 2 | 210 | 6.1 | 34 | 120 | 40 | 20-30 |
| Ex. 3 | 190 | 7.0 | 27 | 120 | 30 | 20-30 |
| Ex. 4 | 210 | 6.1 | 34 | 145 | 50 | 20-30 |
| Ex. 5 | 180 | 6.1 | 30 | 135 | 30 | 20-30 |
| Ex. 6 | 50 | 10 | 5 | 135 | 30 | 30-40 |
| Ex. 7 | 20 | 10 | 2 | 120 | 20 | 30-40 |
| EX. 8 | 250 | 6.5 | 38 | 150 | 170 | 30-40 |
| EX. 9 | 120 | 6.0 | 20 | 180 | 100 | >150 |
| Ex. 10 | 50 | 6.0 | 8 | 360 | 60 | A few hundreds |

With respect to the polishing characteristics of blankets (solid films), in Examples 1 to 5 which are Examples of the present invention, the selective ratio of the removal rates was sufficiently large as compared with Examples 9 and 10 as Comparative Examples. Further, the polishing time of the pattern wafer was short as compared with Examples 8 to 10 as Comparative Examples. Also the dishing fluctuation was improved substantially as compared with Comparative Examples. Further, in each of Examples 1 to 5, the number of scratches was at a level of from 20 to 30 i.e. smaller than Comparative Examples.

Further, in Examples 6 and 7, agglomeration or dispersibility of the abrasive grains was improved substantially as compared with Example 10 as a Comparative Example. Further, the polishing time of the pattern wafer was short, and the dishing fluctuation was less as compared with Example 10. In Examples 6 and 7, agglomeration of abrasive grains was little, and the dispersibility was good, whereby the number of scratches was small as compared with Example 8. Further, in Examples 6 and 7, the selective ratio of removal rates was smaller than in Comparative Examples, because the polishing pressure and the rotational speed were increased, whereby the removal rate of the silicon nitride film was increased. However, the levels of dishing and scratches were comparable to other Examples.

Thus, the semiconductor polishing compound of the present invention is excellent in the planarization characteristics by polishing and in the dispersion stability of abrasive grains in the polishing compound liquid, and is improved further with respect to scratches.

The semiconductor polishing compound of the present invention is excellent in the dispersion stability, and when the polishing compound of the present invention is used, excellent polishing planarization characteristics can be obtained with little dishing fluctuation, and the polishing time of a pattern wafer can be shortened. Further, even if the additive is mixed, the particle diameter will not increase, whereby an improvement is obtainable also with respect to scratches.

By the process for producing a semiconductor polishing compound of the present invention, a semiconductor polishing compound excellent in a long term stability and reproducibility can be prepared.

By the polishing method of the present invention, planarization characteristics can be improved and reduction of scratches is possible, whereby the yield of semiconductor devices can be improved. Further, the polishing time of a pattern wafer can be shortened, whereby the throughput can also be improved.

## Claims

1. A semiconductor polishing compound comprising cerium oxide abrasive grains, water and an anionic additive, wherein the additive is at least one member selected from the group consisting of polyacrylic acid and ammonium polyacrylate, the cerium oxide abrasive grains have a positive surface potential, the pH of the polishing compound at 25°C is from 3.5 to 6, and the total concentration of the additive is from 0.01 to 0.5% based on the total mass of the polishing compound.

2. The semiconductor polishing compound according to Claim 1, wherein the water-soluble organic polymer has a molecular weight of from 1,000 to 500,000.

3. The semiconductor polishing compound according to claim 1 or 2, which further contains an inorganic acid or an inorganic salt.

4. A polishing method which comprises bringing a surface to be polished and a polishing pad in contact with each other and relatively moving them, while supplying a semiconductor polishing compound, **characterized in that** the polishing compound is a semiconductor polishing compound comprising cerium oxide abrasive grains, water and an anionic additive, wherein the additive is at least one member selected from the group consisting of polyacrylic acid and ammonium polyacrylate, the pH of the polishing compound at 25°C is from 3.5 to 6, and the total concentration of the additive is from 0.01 to 0.5% based on the total mass of the polishing compound, the cerium oxide abrasive grains have a positive surface potential, and the surface to be polished is a semiconductor substrate.

5. The polishing method according to Claim 4, wherein the semiconductor substrate is a substrate for a semiconductor device, which comprises at least a silicon oxide film 2.

6. The polishing method according to Claim 4, wherein the semiconductor substrate is one having a silicon nitride film 3 and a silicon oxide film 2 formed on a silicon substrate 1.

## Patentansprüche

1. Halbleiterpolierverbindung, umfassend Ceriumoxidschleifkörner, Wasser und ein anionisches Additiv, wobei das Additiv mindestens ein Vertreter, ausgewählt aus der Gruppe, bestehend aus Polyacrylsäure und Ammoniumpolyacrylat, ist, wobei die Ceriumoxidschleifkörner ein positives Oberflächenpotential aufweisen, der pH der Polierverbindung bei 25°C von 3,5 bis 6 beträgt, und die Gesamtkonzentration des Additivs von 0,01 bis 0,5%, bezogen auf die Gesamtmasse der Polierverbindung, beträgt.

2. Halbleiterpolierverbindung nach Anspruch 1, wobei das wasserlösliche organische Polymer ein Molekulargewicht von 1.000 bis 500.000 aufweist.

3. Halbleiterpolierverbindung nach Anspruch 1 oder 2, welches weiter eine anorganische Säure oder ein anorganisches Salz enthält.

4. Polierverfahren, welches das miteinander Inkontaktbringen einer zu polierenden Oberfläche und eines Polierpads und das relative Bewegen dieser umfaßt, während eine Halbleiterpolierverbindung zugeführt wird, **dadurch gekennzeichnet, daß** die Polierverbindung eine Halbleiterpolierverbindung ist, umfassend Ceriumoxidschleifkörner, Wasser und ein anionisches Additiv, wobei das Additiv mindestens ein Vertreter, ausgewählt aus der Gruppe, bestehend aus Polyacrylsäure und Ammoniumpolyacrylat, ist, der pH der Polierverbindung bei 25°C von 3,5 bis 6 beträgt und die Gesamtkonzentration des Additivs von 0,01 bis 0,5%, bezogen auf die Gesamtmasse der Polierverbindung, beträgt, die Ceriumoxidschleifkörner ein positives Oberflächenpotential aufweisen und die zu polierende Oberfläche ein Halbleitersubstrat ist.

5. Polierverfahren nach Anspruch 4, wobei das Halbleitersubstrat ein Substrat für eine Halbleitervorrichtung ist, welches mindestens einen Siliciumoxidfilm 2 umfaßt.

6. Polierverfahren nach Anspruch 4, wobei das Halbleitersubstrat eines ist, welches einen Siliciumnitridfilm 3 und einen Siliciumoxidfilm 2, gebildet auf einem Siliciumsubstrat 1, aufweist.

## Revendications

1. Composé de polissage de semi-conducteur, comprenant des grains abrasifs d'oxyde de cérium, de l'eau et un additif anionique, l'additif étant au moins l'un des éléments choisis dans le groupe constitué par un acide polyacrylique et un polyacrylate d'ammonium, les grains abrasifs d'oxyde de cérium ayant un potentiel de surface positif, le pH du composé de polissage à 25°C étant de 3,5 à 6 et la concentration totale de l'additif étant de 0,01 à 0,5 % sur la base de la masse totale du composé de polissage.

2. Composé de polissage de semi-conducteur selon la revendication 1, dans lequel le polymère organique soluble dans l'eau a un poids moléculaire de 1.000 à 500.000.

3. Composé de polissage de semi-conducteur selon la revendication 1 ou 2, qui contient par ailleurs un acide inorganique ou un sel inorganique.

4. Procédé de polissage qui consiste à mettre en contact une surface à polir et un tampon de polissage et à les déplacer l'un par rapport à l'autre, tout en amenant un composé de polissage de semi-conducteur, **caractérisé en ce que** le composé de polissage est un composé de polissage de semi-conducteur comprenant des grains abrasifs d'oxyde de cérium, de l'eau et un additif anionique, l'additif étant au moins l'un des éléments choisis dans le groupe constitué par un acide polyacrylique et un polyacrylate d'ammonium, le pH du composé de polissage à 25°C étant de 3,5 à 6 et la concentration totale de l'additif étant de 0,01 à 0,5 % sur la base de la masse totale du composé de polissage, les grains abrasifs d'oxyde de cérium ayant un potentiel de surface positif et la surface à polir étant un substrat de semi-conducteur.

5. Procédé de polissage selon la revendication 4, selon lequel le substrat de semi-conducteur est un substrat pour un dispositif semi-conducteur, qui comprend au moins un film d'oxyde de silicium 2.

6. Procédé de polissage selon la revendication 4, selon lequel le substrat de semi-conducteur est un substrat qui a un film de nitrure de silicium 3 et un film d'oxyde de silicium 2 formés sur un substrat de silicium 1.
